# EUROPEAN PATENT SPECIFICATION

(11) **EP 1 889 286 B1**
(45) Date of publication and mention of the grant of the patent: **28.03.2018**
(21) Application number: 06759431.7
(22) Date of filing: 09.05.2006
(51) Int. Cl.: H01L 21/30

(54) **HIGH EFFICIENCY TRAPPING METHOD FOR DEPOSITION PROCESS**
HOCHEFFIZIENTE METHODE MIT VERWENDUNG EINER FALLE FÜR ABLAGERUNGSVERFAHREN
MÉTHODE DE PIÉGEAGE TRES EFFICACE POUR PROCEDE DE DEPOT

(30) Priority: 06.06.2005 US 145742
(43) Date of publication of application: 20.02.2008
(73) Proprietor: Edwards Vacuum, LLC, Sanborn, NY 14132 (US)
(72) Inventor: HOGLE, Richard, Oceanside, CA 92056 (US)
(74) Representative: Norton, Ian Andrew
(86) International application number: PCT/US2006/017969
(87) International publication number: WO 2006/132751

(56) References cited:
- US-A1- 2003 121 796
- US-A1- 2004 037 768
- US-A1- 2004 081 606
- US-B1- 6 517 913

## Description

### Field of the Invention

The present invention relates to new and useful systems, apparatus and methods in the field to semiconductor manufacturing.

### Background of the Invention

Thin film deposition processes for depositing films of pure and compound materials are known. In recent years, the dominant technique for thin film deposition has been chemical vapor deposition (CVD). A variant of CVD, Atomic Layer Deposition (ALD) has been considered to be an improvement in thin layer deposition in terms of uniformity and conformity, especially for low temperature deposition.

Generally, an ALD process comprises a series of conventional CVD processes, each producing a single-monolayer deposition, wherein each deposition step theoretically goes to saturation at a single molecular or atomic monolayer thickness, and then self-terminates. The deposition is the outcome of chemical reactions between reactive molecular precursors delivered to the system and a substrate. The net reaction must deposit the pure desired film and eliminate the "extra" atoms that compose the molecular precursors.

In the case of CVD, the molecular precursors are fed simultaneously into the CVD reaction chamber. A substrate is kept at a temperature that is optimized to promote chemical reaction between the molecular precursors along with efficient desorption of by-products. Accordingly, the reaction proceeds to deposit the desired thin film.

For ALD applications, the molecular precursors are introduced separately into the ALD reaction chamber. In particular, a first precursor, typically a metal bonded to an atomic or molecular ligand to make a volatile molecule, that reacts with the substrate, is introduced. The metal precursor reaction is normally followed by inert gas purging to clear the chamber prior to the introduction of the next precursor. Thus, in contrast to the CVD process, ALD is performed in a cyclic fashion with sequential alternating pulses of the precursors and purge gases. Typically, only one monolayer is deposited per operation cycle. Generally, ALD processes are conducted at pressures less than 1 Torr.

ALD processes are commonly used in the fabrication and treatment of integrated circuit (IC) devices and other substrates where defined, ultra-thin layers are required. One problem related to ALD processes is the production of by-products that adhere to and otherwise cause deleterious processing effects in the deposition apparatus components. In particular, the by-products may deposit in the vacuum pump causing pump seizure, pump failure, and impure deposition. In addition, the by-products may adhere to the reaction chamber walls or other apparatus components, requiring the deposition process to be shut down while the by-products are removed, or the fouled components are replaced. The suspension of the production process as well as the cleaning or replacement of components is time consuming and costly.

Such drawbacks also occur in CVD processes, but occur with greater frequency during ALD, because the intended reaction is a surface reaction on the substrate being treated. Therefore, in ALD processes, a majority of the supplied gas leaves the reaction chamber "unreacted", and further mixes with gases from the previous and subsequent reaction steps. As a result, a significant volume of the unreacted gases may react outside the reaction chamber in locations such as in the process foreline and the pumps. This may result in higher unwanted non-chamber deposition rates, which leads to pump and foreline "clogging" and results in pump seizure or failure noted above.

Various solutions have been attempted, but are also time-consuming, costly, or otherwise impractical for various reasons including space allocation. For example, one approach employs a valve at the exhaust of the reaction chamber that physically switches the exhaust flow alternately to one of two forelines and vacuum pumps. The valve operation is synchronized with the cycle times used to pulse different gases into the reaction chamber, in an attempt to avoid commingling of the gases in the chamber, forelines and pumps. However, this solution requires each pump exhaust to be routed separately to an abatement unit, adding significant processing cost. Further, portions of the reactant gases may still combine and react before they reach the chamber exhaust valve. Other solutions employ a foreline trap, to either trap the process by-products, or selectively trap one or more of the reactant species to avoid cross-reaction. These systems have not proved to be efficient. Another proposed solution, disclosed in JP 11181421 introduces C1F₃ or F₂ to react with by-products formed during CVD that adhere to pipe surfaces. However, this approach is unworkable for ALD systems where there are higher amounts of by-products exiting the reaction chamber.

Another approach suggested by co-pending application, US SN 11/018641 (published as US2005/250347 A), provides a method, system and apparatus for improving the efficiency of a deposition system by decreasing or substantially eliminating the amount of by-products produced during the deposition system by providing a fluorine atmosphere in the deposition process, the atmosphere comprising molecular fluorine (F₂) or fluorine in the radical form (F*), and the fluorine atmosphere introduced to the apparatus in the foreline. However this approach will not work when hydrogen is added to the deposition process. This is because the fluorine will react preferentially with the hydrogen. Therefore, unless an excess of fluorine is added, there will be no fluorine left to create the desired fluorine atmosphere. The amount of excess fluorine needed depends on the amount of hydrogen added to the process, but could easily result in significant cost for the fluorine, equipment and energy.

US6517913 B shows an apparatus for converting PFC gases from semiconductor processing equipment to less harmful species.

Therefore, there remains a need in the art to overcome the problems associated with by-product accumulation in the apparatus components of a deposition process.

### Summary of Invention

The present invention overcomes the problems noted above and provides a method for improving the efficiency of a semiconductor processing system, such as a deposition system by decreasing or substantially eliminating the accumulation of by-products in the apparatus components of the semiconductor processing system, as defined in the accompanying claims appended hereto.

The present invention further relates to improving the efficiency of a foreline trap associated with a semiconductor processing system, wherein the trap removes substantially all of the by-products from the exhaust gas from the processing chamber.

In addition, the present invention provides a method for efficiently clearing traps of accumulated by-products from exhaust gas of a semiconductor processing system.

### Brief Description of Drawings

Figure 1 is a schematic drawing of a trap for a semiconductor processing system.
Figure 2 is a schematic drawing showing an apparatus employing multiple traps in series.
Figure 3 is a schematic drawing showing another apparatus employing multiple traps in parallel series.
Figure 4 is a schematic drawing showing an apparatus employing multiple traps in series and further including a fluorine source.
Figure 5A is a schematic drawing showing a further apparatus employing multiple traps in series with a fluorine source associated with each series of traps.
Figure 5B is a schematic drawing showing a further apparatus employing multiple traps in series with a single fluorine source operable with each series of traps.
Figure 6 is a schematic drawing showing another apparatus employing multiple traps in series and having a fluorine source associated with each trap.
Figure 7A is a schematic drawing showing another apparatus employing multiple traps in series and having a fluorine source associated with each trap in each series.
Figure 7B is a schematic drawing showing apparatus employing multiple traps in series and having a series of fluorine sources for associated with each series of traps.
Figure 8 is a schematic drawing showing an embodiment of the present invention employing a single trap and having a reactive gas source and a fluorine source associated with the trap.
Figure 9A is a schematic drawing showing a further embodiment of the present invention employing multiple traps in parallel and having a reactive gas source and a fluorine source associated with each trap.
Figure 9B is a schematic drawing showing a further embodiment of the present invention employing multiple traps in parallel and having a single reactive gas source and a single fluorine source associated with the traps.

### Detailed Description of the Invention

As noted above, the accumulation of by-products from a semiconductor manufacturing process, in the apparatus components of the processing system can cause equipment failure and also may require system shut-down to clean the components, resulting in substantial cost.

Also as noted, various approaches have been attempted to overcome the problem of by-product accumulation. This includes employing a fore-line trap, which as noted, has not proved to be efficient.

The present invention solves the problem of fore-line trap inefficiency. In particular, the present invention provides a semiconductor manufacturing system using a fore-line trap that can remove 99% or more of the by-products from the exhaust gas from the processing chamber. In addition, the present invention provides for means to clean the trap of accumulated by-products without requiring shut-down of the deposition system, resulting in significant cost savings. The present invention will be described in greater detail below, with reference to the drawing figures.

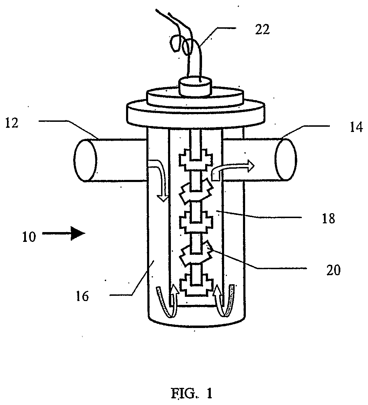

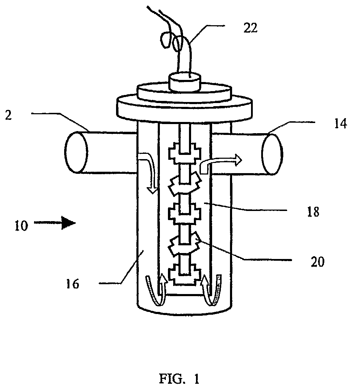

In particular, Fig. 1 shows a standard hot trap 10, having an inlet 12, an outlet 14, an outer chamber 16, an inner chamber 18 and baffles 20. In operation, exhaust gas enters the hot trap 10, through inlet 12, flows through the outer chamber 16 and then into the inner chamber 18. The baffles 20 are kept at a desired operating temperature, by an appropriate heating means, such as an electrical heating means 22. The exhaust gas reacts with and accumulates on the hot baffles 20, and the rest of the exhaust gas exits the hot tap 10, through outlet 14.

There are two problems associated with the use of a hot trap 10, as shown in Fig. 1. First, in order for the trap to be useful in a semiconductor processing system, the removal of by-products must be greater than 99%. In tests performed with respect to the present invention, a hot trap as shown in Fig. 1, operating at a baffle temperature of about 500° C proved to be only about 70% efficient. Second, assuming the efficiency of the hot trap can be improved to more than 99%, a significant amount of by-product, as much as ten pounds a week, will accumulate in the trap, which must be removed and may cause costly cleaning and down time. The present invention addresses both of these issues.

In order to increase the trap efficiency, the present disclosure provides a series of traps to increase the overall trap length. For example, if a particular trap having a length, L, provides 70% removal of by-products for a given set of process flows and chemistries, then by adding a second trap of the same configuration including length L, the total trapping efficiency can be increased to 91%. In particular, the first trap will remove 70% of the by-products and the second trap will remove 70% of the remaining 30% of the by-products that exit the first trap. More traps can be added to increase total trapping efficiency even further. The tables below show the number of lengths, L, and total trapping efficiencies assuming a single trap efficiency of 70% (Table 1), 50% (Table 2) and 90% (Table 3).

| TABLE 1 | | |
|---|---|---|
| Single Trap Efficiency = 70% | | |
| Total Trap Length | Total Trapping Efficiency (%) | Effluent By-Product Content (%) |
| 1L | 70 | 30 |
| 2L | 91 | 9 |
| 3L | 97.3 | 2.7 |
| 4L | 99.19 | 0.81 |
| 5L | 99.757 | 0.243 |
| 6L | 99.9271 | 0.0729 |

| TABLE 2 | | |
|---|---|---|
| Single Trap Efficiency = 50% | | |
| Total Trap Length | Total Trapping Efficiency (%) | Effluent By-Product Content (%) |
| 1L | 50 | 50 |
| 2L | 75 | 25 |
| 3L | 87.5 | 12.5 |
| 4L | 93.75 | 6.25 |
| 5L | 96.875 | 3.125 |
| 6L | 98.4375 | 1.5625 |
| 7L | 99.21875 | 0.78125 |

| TABLE 1 | | |
|---|---|---|
| Single Trap Efficiency = 90% | | |
| Total Trap Length | Total Trapping Efficiency (%) | Effluent By-Product Content (%) |
| 1L | 90 | 10 |
| 2L | 99 | 1 |
| 3L | 99.9 | 0.1 |
| 4L | 99.99 | 0.01 |

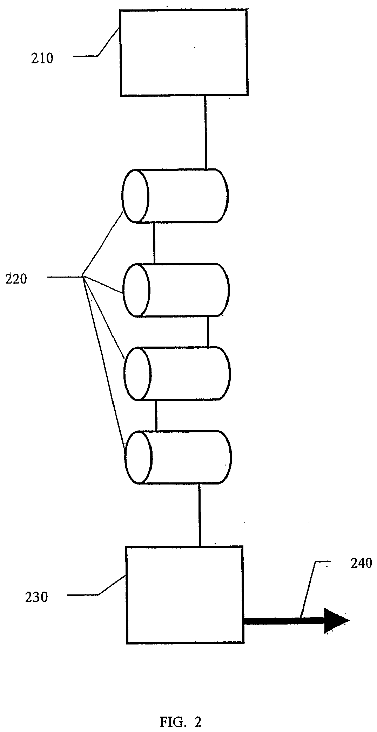

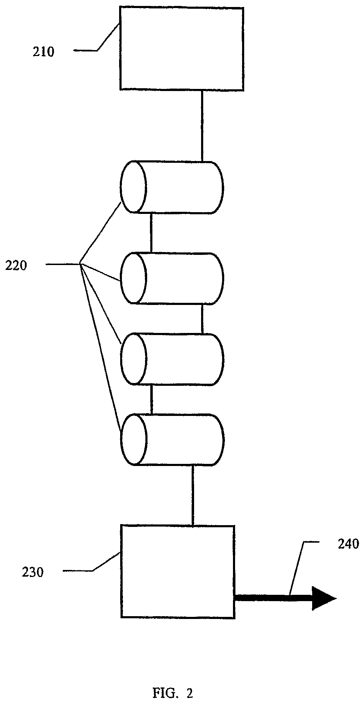

A trap is shown in Fig. 2, wherein exhaust gases from a processing chamber 210, pass through a series of hot traps 220, prior to flowing through a vacuum pump 230, and exiting as waste stream 240. Four hot traps 220, are shown in Fig. 2, but any number of traps necessary to meet the desired total trapping efficiency can be used. A single series path of hot traps is shown in Fig. 2 and is acceptable for use when there is sufficient time between process runs in the processing chamber to allow for trap cleaning. In addition, as shown in Fig. 2, each trap in the series is of the same type and has the same parameters, including length, L, and trapping efficiency. The present invention also includes arrangements wherein the traps in the series are of different types, or have different parameters, such as different lengths. Any combination of traps in the series is acceptable, as long as the total trapping efficiency required for the system is met.

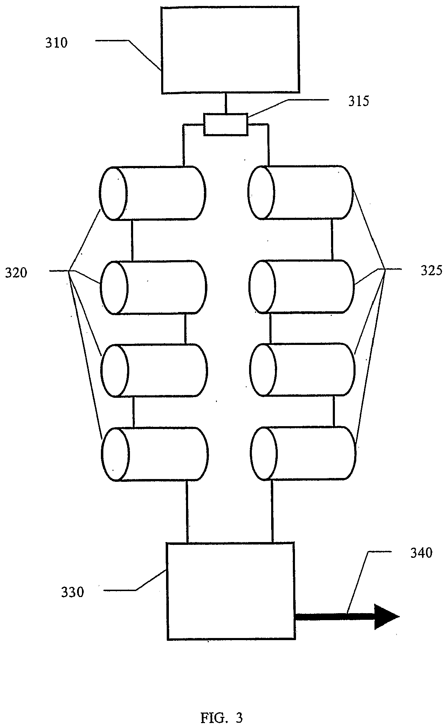

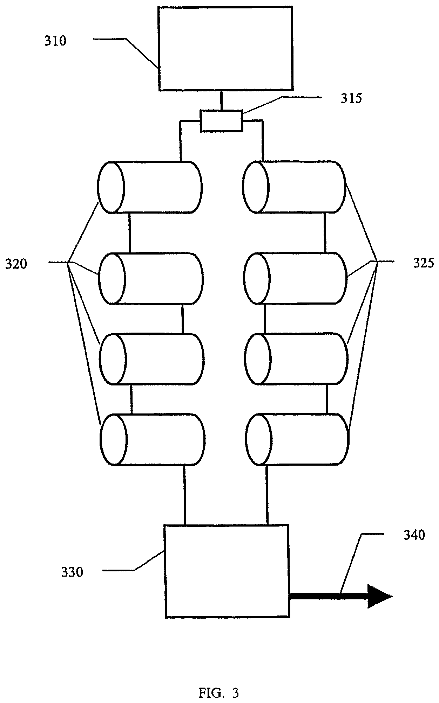

Another trap is shown in Fig. 3, that is useful when there is not enough time to allow for cleaning of the traps, or when a more continuous operation is desired. In particular, Fig. 3 shows two parallel series paths of hot traps, a first series of hot traps 320, and a second series of hot traps 325. The system shown in Fig. 3 also includes a three way valve 315, to allow the exhaust gas from the processing chamber 310, to be switched from on series of traps to the other. This allows for continuous operation; for example, when the first series of traps 320 is receiving the exhaust gas and trapping by-products, the second series of traps 325, can be cleaned, and vice versa. In either case, once the exhaust gas passes through a series of traps, it can then pass through the vacuum pump 330, without significant by-product deposition and then on to the waste stream 340. By using the system of the present invention, by-product buildup in the vacuum pump and other components can be avoided and the risk of pump seizure or failure, as well as system clogging can be nearly eliminated.

Once again, while four traps are shown in each series of traps in Fig. 3, any number of traps can be used to meet the desired trapping efficiency. Generally, it is desirable that both of the parallel series of traps include the same number o traps, but the present invention includes alternative arrangements wherein the different series of traps include different numbers of traps. As noted above, any combination of traps in a series is acceptable, as long as the required total trapping efficiency is met. Normally, the required total trapping efficiency would be the same for both series, but such is not required by the present invention. Rather, the different series of traps can have different required total trapping efficiencies. While two parallel series of traps should be sufficient for the majority of semiconductor manufacturing systems to enable continuous operation, one or more additional series of traps can be added if necessary.

The systems shown in Figs. 2 and 3 solve the first problem noted above, i.e. increasing the total trapping efficiency of a hot trap. However, the second problem of cleaning the by-product accumulation from the hot traps in the systems shown in Figs. 2 and 3 would require dismantling and difficult cleaning operations or replacement of traps on a regular basis. Therefore, the present invention also provides a means to more easily clean the traps.

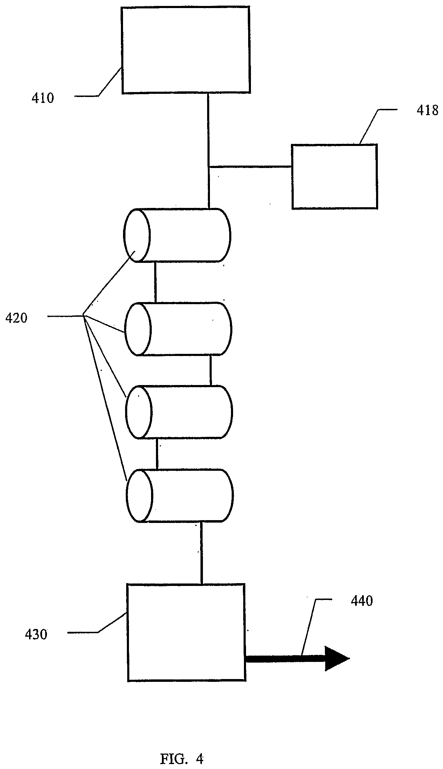

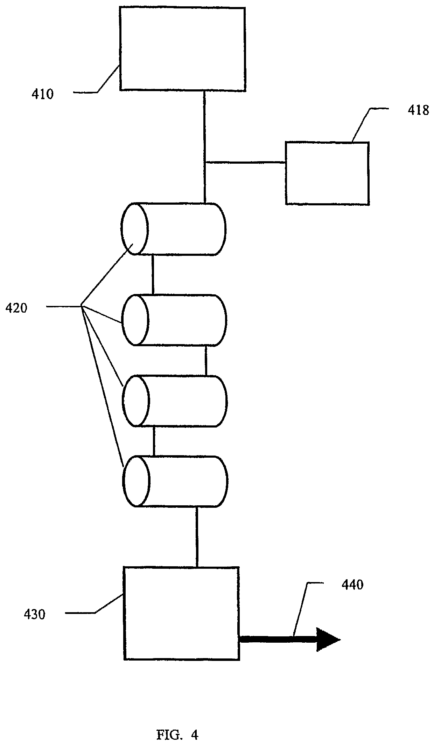

In particular, traps can be cleaned is shown in Fig. 4, wherein exhaust gas from a processing chamber 410, passes through a series of hot traps 420, to remove more than 99% of the by-products prior to reaching a vacuum pump 430, and being sent to waste stream 440. The system shown in Fig. 4 also includes a fluorine source 418, to provide fluorine to the system that can etch the by-products and clean the traps 420. The fluorine source 418, can be any suitable source known in the industry, such as MKS Astron or MKS Astroni, or may be excess fluorine that has passed through the processing chamber 410, during a chamber cleaning or other process. The fluorine provided to the system etches the by-products deposited in the hot traps 420, and the effluent can then be processed by the vacuum pump 430, without risk of further deposition and sent to the waste stream 440. As noted above with respect to other embodiments, there can be any number of hot traps having the same or different parameters, as long as the required total trapping efficiency is accomplished.

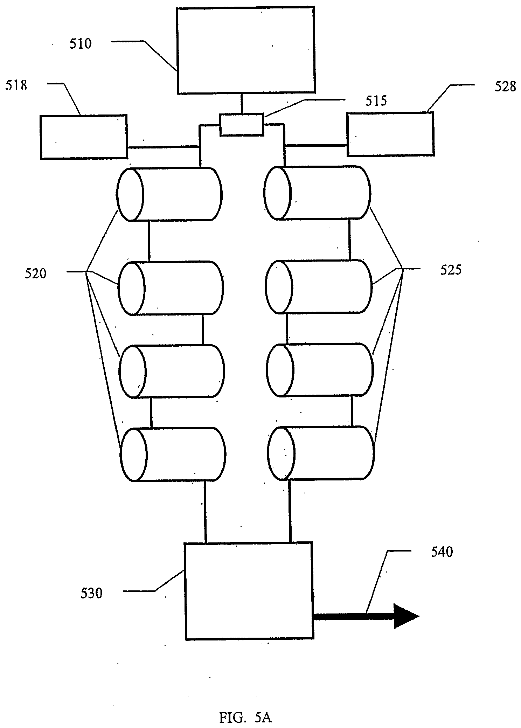

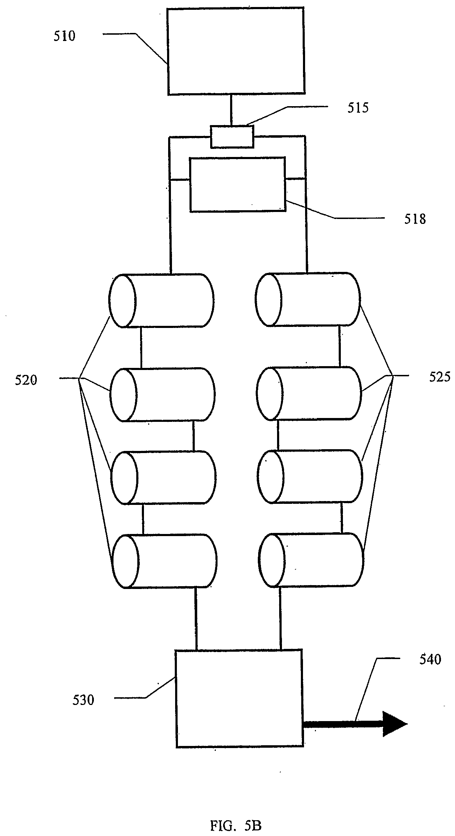

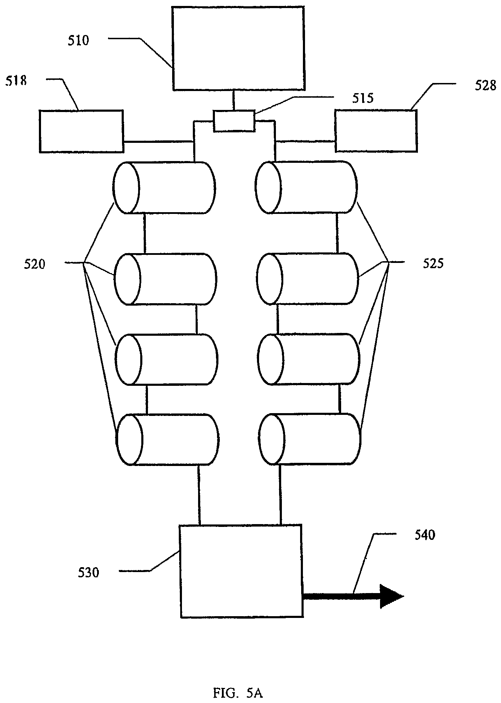

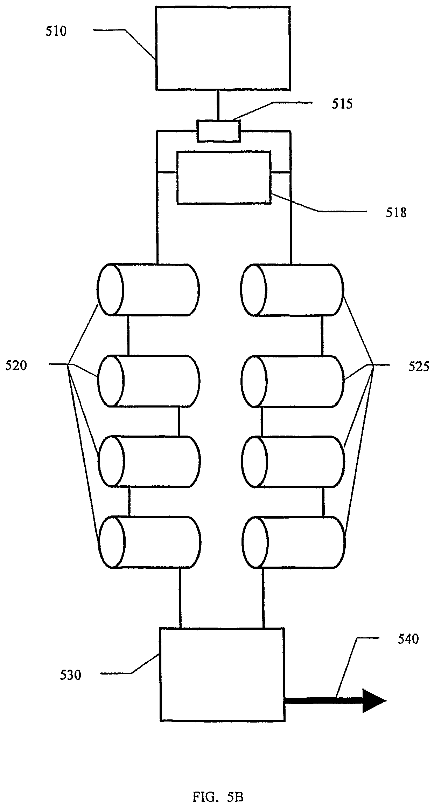

Fig. 5A shows another apparatus wherein two parallel series of hot traps, a first series of hot traps 520, and a second series of hot traps 525, are utilized to remove by-products from the exhaust gas of a processing chamber 510. A three way valve 515 is provided to allow the exhaust gas to be switched from one series of hot traps to the other and to enable continuous operation. The system of Fig. 5 also includes a fluorine source 518, associated with hot traps 520, and a fluorine source 528, associated with hot traps 525, that provides fluorine to the system to etch by-products from and clean the hot traps. The processed exhaust gas, as well as the fluorine gas and cleaned by-products are then sent through a vacuum pump 530 and out of the system as waste 540. The fluorine sources can be any of those mentioned above and the hot traps can be provided in any of the configurations noted above, as long as the required total trapping efficiency is met. Fig. 5B show a further embodiment of the present invention, wherein a single fluorine source 518, is used for both series of hot traps 520, and 525. This reduces the overall number of components necessary in the system, but otherwise operates in the same manner as described with respect to the embodiment of Fig. 5A.

The configurations shown in Figs 4 and 5 will work adequately only if the hot traps have a high enough surface temperature. In particular, it has been found that molecular fluorine (F2) will not etch by-products from the surfaces of apparatus components. Rather, fluorine radicals (F*) are necessary. Further, at relatively low temperatures, F* will quickly recombine to F2 and therefore be unable to perform the cleaning operation. However, at high temperatures, F* can be maintained and cleaning operations can be successfully carried out. Further, once etching has been started, the heat of reaction may allow the reaction to continue, even with heaters turned off. In fact, in some instances, it may be necessary to provide cooling means. Therefore, when a high enough initial temperature is established, about 150°C or higher, then the configurations of Figs. 4 and 5, using a single fluorine source for each series of traps or for the entire system, is possible. In other words, a single fluorine source can be used for high temperature hot traps, and F* existence and reaction with the by-products, can be sustained throughout the series of traps.

However, if surface temperatures in the hot traps are not hot enough or drop too low, the F* will quickly revert to F2 and not be able to carry out the cleaning operation. In general, F* would not survive past the first trap in a series. Therefore, it is necessary to provide multiple fluorine sources.

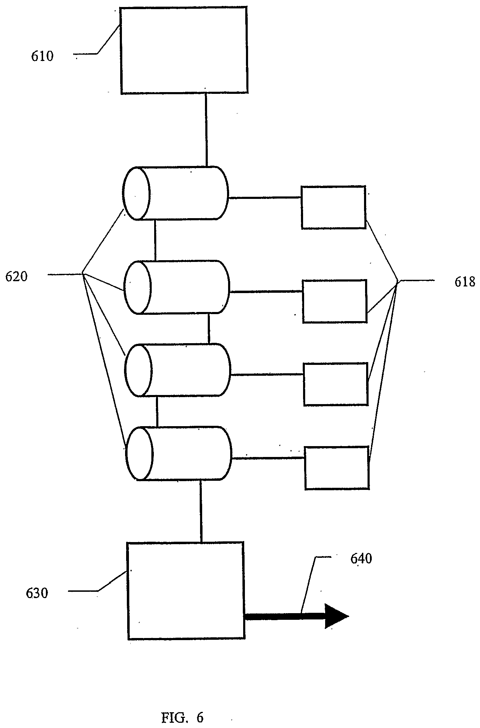

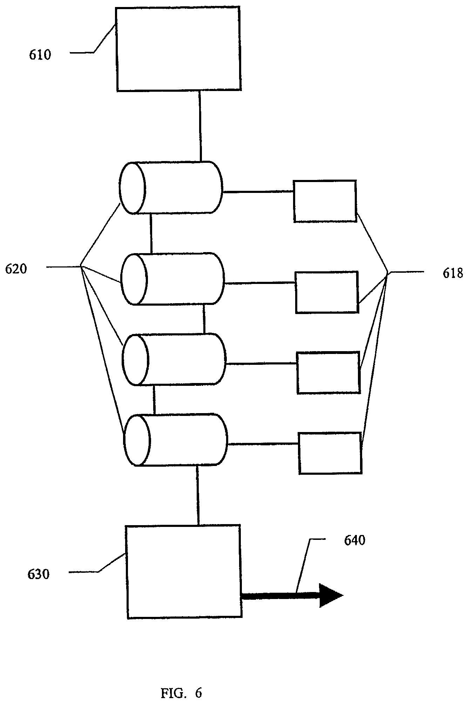

Fig. 6 shows one apparatus wherein a series of fluorine sources 618 are provided, one for each trap in the series of traps 620. As in the embodiments described above, exhaust from a processing chamber 610, passes through the series of traps 620, and then sufficiently depleted of by-products, passes through the vacuum pump 630, and out of the waste stream 640. Each of the fluorine sources 618, provides F* to an associated trap 620. The F* cleans the deposited by-products from the traps and is also processed by the vacuum pump 630 and sent to the waste stream 640. Any suitable number of traps, with the same or different operating parameters can be used in the arrangement shown in Fig. 6. Further, it may be possible to combine one or more of the fluorine sources 618, and provide separate paths between the fluorine source 618, and the individual traps 620.

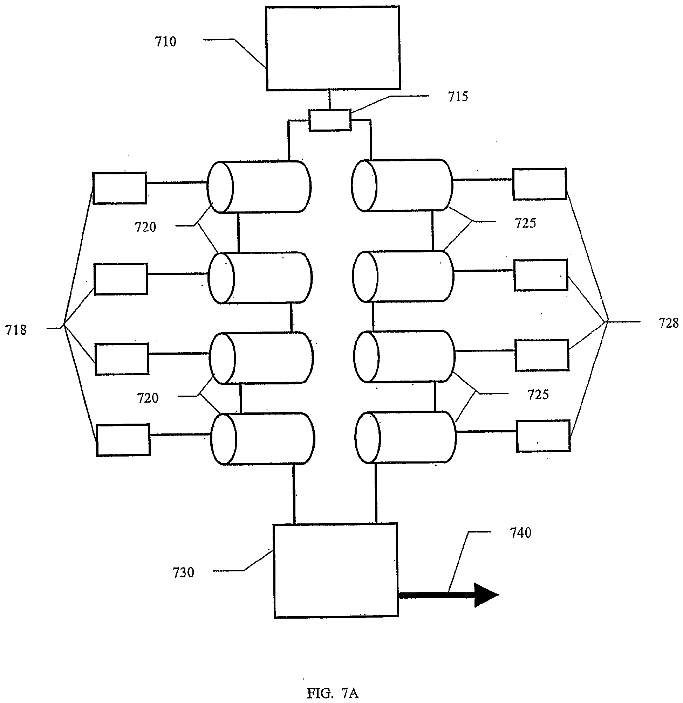

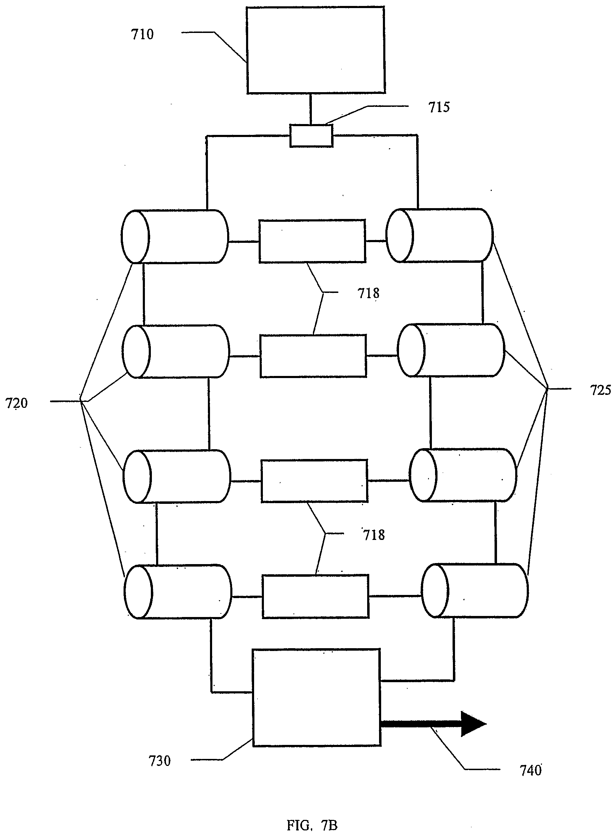

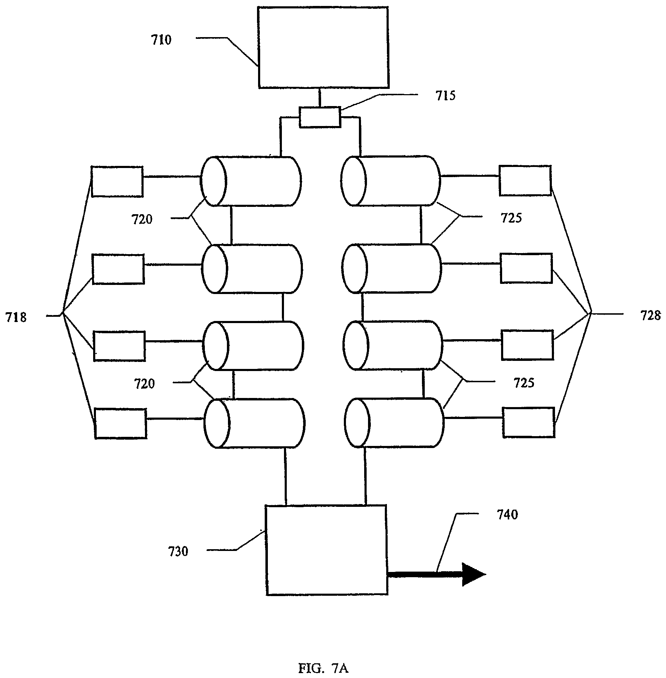

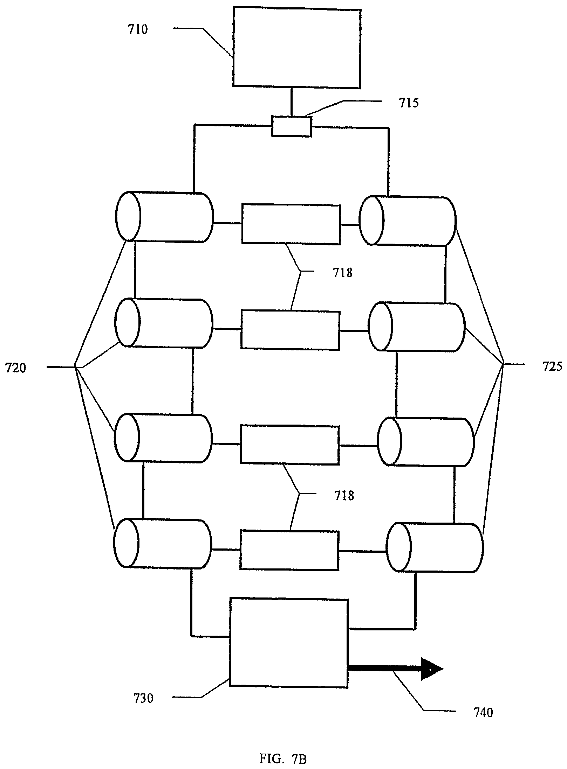

Fig. 7A depicts a further apparatus that also employs multiple fluorine sources. The arrangement shown in Fig. 7A includes two parallel series of traps, a first series of traps 720, and a second series of traps 725, that receive exhaust gas from a processing chamber 710, as controlled by a three way valve 715. This parallel arrangement may be required when a continuous process is desired or if there is insufficient time to perform the trap cleaning operation between process runs in the processing chamber 710. In this configuration, a first series of fluorine sources 718, provides F* to the first series of traps 720, and a second series of fluorine sources 728, provides F* to the second series of traps 725. The exhaust stream and cleaning step exhaust are all sent through vacuum pump 730, and into waste stream 740. Any appropriate number and operating design for the traps, as discussed above with respect to other embodiments can be used. In operation, exhaust gas from processing chamber 710, is provides to one series of traps while the other series of traps is being cleaned. Fig. 7B provides a further embodiment of the present invention where a single series of fluorine sources 718 is used to provide F* to both series of traps 720 and 725. Operation and system arrangements are the same as described with respect to the embodiment shown in Fig. 7A.

The above apparatuses will require the use of multiple traps to increase trapping efficiency and means to clean the traps of deposited by-products. In an embodiment of the invention, the reaction of by-products is driven to completion, by injecting a gas to the trap. For example, ammonia gas can be added for many semiconductor processes to cause the reaction process to be completed in the trap. In this way, fouling of the pump and other apparatus components is avoided. Fluorine is then provided to the trap to clean the deposited by-products and remove them from the system. By using the reactive gas in the trap, the trapping efficiency is increased and the need to extend the overall length of the trap through the use of multiple traps is avoided.

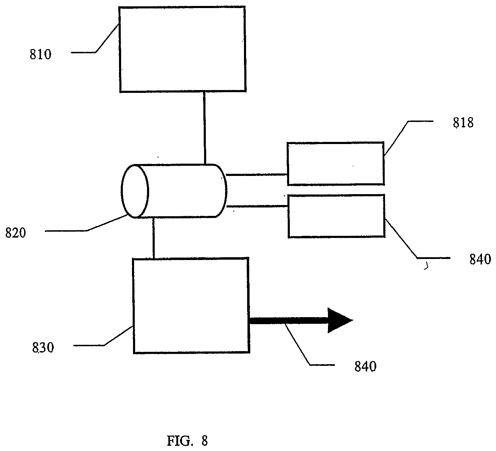

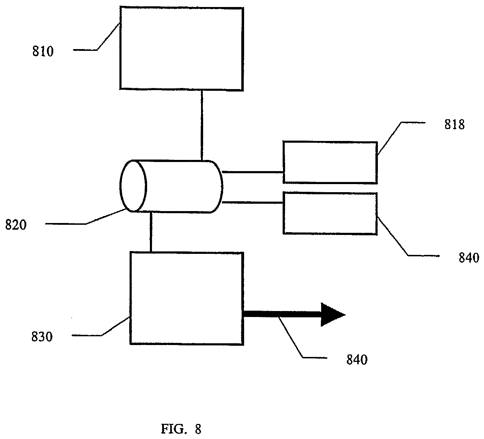

An embodiment employing a reactive gas is shown in Fig. 8, wherein exhaust gas from a processing chamber 810, is sent through a trap 820, to remove by-products, prior to exiting the system through vacuum pump 830, as waste stream 840. A reactive gas source 840, and a fluorine source 818, are also included. The reactive gas source 840, provides a reactive gas, such as ammonia gas, to the trap 820, in order to complete the reaction of the by-products in the trap 820, and increase the trapping efficiency of the trap 820 to the desired level. Fluorine from fluorine source 818, is then provided to the trap 820, to etch the deposited by-products from the trap 820. The components employed in this embodiment can be of any standard design, as described above with respect to other embodiments.

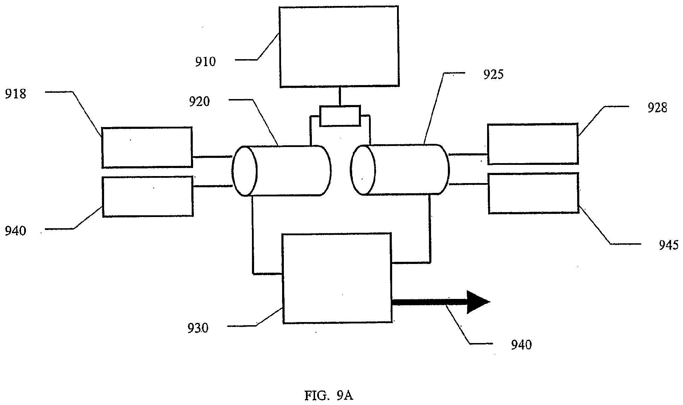

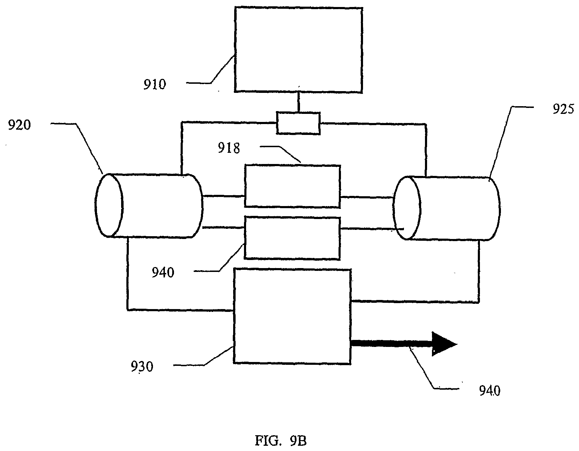

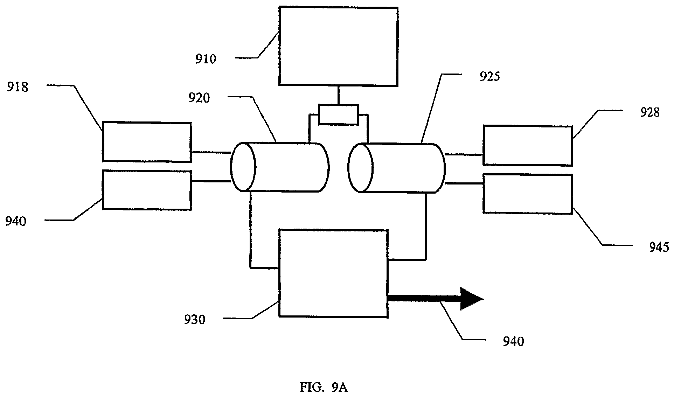

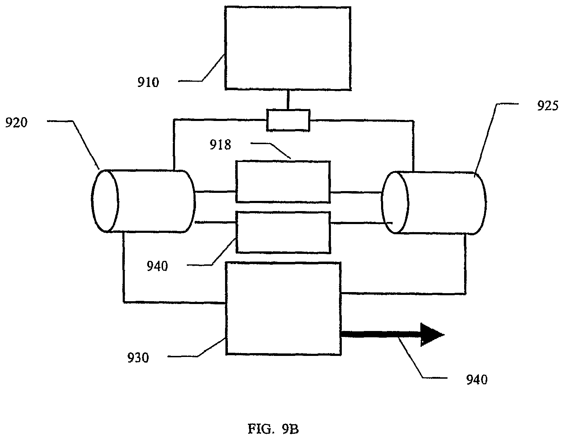

Figures 9A and 9B show further embodiments employing two traps 920 and 925, for processing the exhaust gas from processing chamber 910. Providing two separate traps allows for continuous operation, as three way valve 915 provides a means to direct the exhaust gas to either of the traps 920 or 925. In the embodiment shown in Fig. 9A, each trap 920 and 925, have a reactive gas source 940 and 945 respectively and a fluorine source 918 and 928, respectively, associated therewith. In the embodiment shown in Fig. 9B, as single reactive gas source 940, and a single fluorine source 918, service both traps 920 and 925. In operation, when the reactive gas, such as ammonia gas, is provided to trap 920, F* is provided to trap 925, and vice versa. In this way, while one trap is removing by-products from the exhaust gas, utilizing the reactive gas to drive the reaction to completion, the other trap is being cleaned of deposits. All of the gases can then pass through the vacuum pump 930, and out of the system as waste stream 940. The components shown in Fig. 9A and 9B can be of any standard design, the same or different, as described above with respect to other embodiments. Further, while completely separate or completely shared reactive gas and fluorine sources are shown, other arrangements are possible. For example, a single reactive gas source could be used for both traps, but separate fluorine sources, one for each trap could be included. Alternatively, separate reactive gas sources, one for each trap could be used, but a single shared fluorine source could be employed.

In all cases, parallel paths are required only if the timing sequence of the processing chamber does not allow sufficient time for trap cleaning between processes. Further, in those embodiments where series of traps are provided, the number and configuration of the traps need only be that necessary to meet the required trapping efficiency. The injection of a reactive gas, such as ammonia, provides an alternate solution to the provision of series of traps. The embodiments described all show the traps up stream or ahead of a single pump. However, the pumping system could comprise multiple pumps in series or parallel configuration and the traps could be placed before all the pumps or between pumps. In addition, when parallel paths are employed, separate pumps could be used, for example, one pump could pump the treated exhaust gas and a second pump could pump the etched by-product and cleaning gas.

The present invention solves the problems associated with buildup of deposited by-products in vacuum pumps and other apparatus components of a semiconductor processing system. The present invention employs traps to remove substantially all of the by-products from the exhaust gas of a vacuum processing unit and therefore avoids clogging and potential seizure or failure of pumps and other components of the system. In addition, the present invention provides means to clean the traps of accumulated by-product and alternatively to allow for continuous operation of the semiconductor processing system.

It is anticipated that other embodiments and variations of the present invention will become readily apparent to the skilled artisan in the light of the foregoing description, and it is intended that such embodiments and variations likewise be included within the scope of the invention as set out in the appended claims.

## Claims

1. A method of removing deposition process by-products from an exhaust gas of a semiconductor processing unit, said method comprising:
passing said exhaust gas through a trap;
introducing a reactive gas to said trap to drive the reaction of said deposition process by-products in said exhaust gas to completion in said trap; and
introducing fluorine to said trap to etch accumulated deposition by-products from said trap.

2. A method of removing deposition process by-products from an exhaust gas of a semiconductor processing unit according to claim 1, said method comprising:
providing two separate traps and a three way valve to direct gas to either of the traps;
providing a reactive gas to first trap;
providing F* to a second trap; and
passing all the gases through a vacuum pump.

## Patentansprüche

1. Verfahren zum Entfernen von Beschichtungsprozess-Nebenprodukten aus einem Abgas einer Halbleiter-Verarbeitungseinheit, wobei das Verfahren umfasst:
Leiten des Abgases durch eine Falle,
Einleiten eines reaktiven Gases in die Falle zum Befördern der Reaktion der Beschichtungsprozess-Nebenprodukte in dem Abgas in der Falle bis zur Vollständigkeit, und
Einleiten von Fluor in die Falle zum Wegätzen angesammelter Beschichtungsnebenprodukte aus der Falle.

2. Verfahren zum Entfernen von Beschichtungsprozess-Nebenprodukten aus einem Abgas einer Halbleiter-Verarbeitungseinheit nach Anspruch 1, wobei das Verfahren umfasst:
Vorsehen von zwei separaten Fallen und einem Dreiwegeventil zum Leiten von Gas zu jeder der Fallen,
Zuführen eines reaktiven Gases in die erste Falle,
Zuführen von F* zu einer zweiten Falle, und
Leiten aller Gase durch eine Vakuumpumpe.

## Revendications

1. Méthode d'élimination de sous-produits provenant d'un procédé de dépôt dans un gaz d'échappement d'une unité de traitement de semi-conducteurs, ladite méthode comprenant les étapes suivantes :
faire passer ledit gaz d'échappement à travers un piège ;
introduire un gaz réactif audit piège pour conduire la réaction desdits sous-produits provenant d'un procédé de dépôt dans ledit gaz d'échappement à son terme dans ledit piège ; et
introduire du fluor audit piège pour éliminer par gravure des sous-produits de dépôt accumulés dudit piège.

2. Méthode d'élimination de sous-produits provenant d'un procédé de dépôt dans un gaz d'échappement d'une unité de traitement de semi-conducteurs selon la revendication 1, ladite méthode comprenant les étapes suivantes :
fournir deux pièges séparés et une vanne trois voies pour diriger du gaz vers l'un ou l'autre des pièges ;
fournir un gaz réactif à un premier piège ;
fournir du F* à un second piège ; et
faire passer tous les gaz à travers une pompe à vide.
